# EUROPEAN PATENT SPECIFICATION

(11) **EP 2 533 279 B1**
(45) Date of publication and mention of the grant of the patent: **15.08.2018**
(21) Application number: 12170937.2
(22) Date of filing: 06.06.2012
(51) Int. Cl.: H01L 21/687, H01L 21/67, G03F 7/20, H01L 21/683, B29C 33/42, B29C 43/00, B29C 43/02, B29C 43/18

(54) **Support and transport unit for a print substrate for a plant for depositing print tracks, and relative deposition method**
Träger- und Transporteinheit für Drucksubstrat für eine Anlage zur Ablagerung von Druckspuren sowie dazugehöriges Ablagerungsverfahren
Unité de transport et de support pour substrat d'impression pour une installation de dépôt de pistes d'impression et procédé de dépôt relatif

(30) Priority: 06.06.2011 IT UD20110079; 05.10.2011 US 201161543650 P
(43) Date of publication of application: 12.12.2012
(73) Proprietor: APPLIED MATERIALS ITALIA S.R.L., 31048 San Biagio di Callalta (TV) (IT)
(72) Inventor: Pasqualin, Gianfranco, 31027 Spresiano (TV) (IT); Galiazzo, Marco, 35127 Padova (IT); Tonini, Diego, Treviso 31100 (IT); Furin, Valentina, 31100 Treviso (IT); Rocco, Giordano, 31010 Mareno di Piave (TV) (IT); Cellere, Giorgio, 36040 Torri di Quartesolo (VI) (IT)
(74) Representative: Zimmermann & Partner Patentanwälte mbB

(56) References cited:
- US-A- 4 954 313
- US-A1- 2007 262 049

## Description

### CROSS-REFERENCE TO RELATED APPLICATIONS / PRIORITY CLAIM

This application claims the benefit of U.S. Provisional Application No. 61/543,650, filed on October 5, 2011 and Italian Patent Application No. UD2011A000079 filed June 6, 2011.

### FIELD OF THE INVENTION

Aspects of the present invention generally relate to methods and devices for depositing printing material on a substrate. Some embodiments presented herein concern a support and transport unit for a print substrate for a plant for depositing print tracks, for example in silk-screen printing, ink jet printing, laser printing or other technologies. Embodiments may be used to make photovoltaic cells, for example by printing conductive tracks with multiple layer patterns on substrates, plates or similar elements such as a wafer, a sheet of foil, or a silicon based object. Embodiments may also be used with print support elements from other fields in which a printing operation is provided.

### BACKGROUND OF THE INVENTION

Print machines are known for making solar cells, photovoltaic cells or similar semiconductor devices, which use silk-screen printing methods to make electronic circuits and contacts with the cells from suitable conductive materials, or conductive pastes, or contact pastes.

The print machine generally used in such methods comprises appropriate work stations, from and toward which each of the cells is moved on a support unit, also called a printing nest, associated with a rectilinear conveyor belt or a machine with rotary work stations. The printing nest has a work surface or plane on which the substrates to be worked are rested on each occasion.

More specifically, the printing nest comprises a support surface provided with a fluid-dynamic circuit having a plurality of channels interconnected with each other, which open toward a surface on which the substrate is disposed in order to make the cell. The fluid-dynamic circuit is associated with a suction device, which may determine a state of suction (or lower pressure than the ambient pressure) and/or partial vacuum on the substrate in order to keep it adherent to the printing nest and to prevent the substrate from moving from a correct printing position. A layer of transpirable material, such as cigarette paper, is disposed between the surface of the printing nest and the substrate to prevent the surface of the printing nest from getting dirty during the printing of the cell and to prevent the substrate from being damaged on its lower surface.

One method is to position a substrate on the printing nest, and then to take the substrate to a station for a printing operation. During the printing operation, on the surface of the substrate facing toward the print machine, conductive tracks are made and holes (through the substrate) are metalized. During the metalization process, the holes are completely or partly filled with metal paste (for example silver-based metal paste), which has a conductive and/or contact function between the front surface (to which the connections may be directly connected) and the rear surface of the cell.

During the printing operation, the activation of the suction circuit has the function of correctly filling the holes present in the substrate with conductive paste. This allows for exploiting the fluid properties of the material that is printed.

The fluid-dynamic circuit with which the printing nest is provided therefore performs both the function of holding the substrate to be printed during the print operations and the function of moving it, and also that of providing, in the printing step, that the holes are correctly and completely filled.

During this operation, however, it often happens that the conductive paste leaks from the substrate and soils the layer of transpirable material, which necessarily has to be replaced or restored. To this purpose, the printing nest is normally provided with a loader to load the layer of transpirable material, which comprises a feed reel and a collection reel associated with movement means.

Given the high productivity of print machines, frequent replacement of the layer of transpirable material may be required to prevent the paste deposited from creating unwanted thicknesses on which the subsequent wafers rest, which may cause printing imperfections and/or may dirty subsequent wafers. Accordingly, frequent replacement of the transpirable material may cause unwanted conductive conditions and low quality printing.

The frequent replacement of the transpirable material may also entail frequent downtimes for replacing the belt, along with increased costs due to the replaced belt. Further, frequent replacement of the transpirable material may introduce the possibility of errors in positioning and manufacturing subsequent wafers.

Moreover, given that the fluid-dynamic circuit performs both the function of keeping the substrate adherent to the printing nest, and also of allowing the holes of the substrate to be filled, it is not possible to control both actions properly, since they require different working pressures. This leads, most times, to an uncontrolled filling of the holes of the substrate and a consequent unwanted leakage of paste from behind the cell.

US 2007/262049 A1 discloses an imprinting method carrying out imprinting on a workpiece by clamping UV-curable resin between a nano-imprinting mold and a workpiece and curing the UV-curable resin using UV light. In this method, the workpiece is supported on a setting table provided with through-holes that are disposed in a planar region of the setting table on which the workpiece is set and are connected to a gas pumping/evacuating mechanism. The UV-curable resin is supplied onto the workpiece and the setting table is raised to and stopped at a filling operation position where the mold surface of the nano-imprinting mold and the surface of the workpiece are apart. After this, gas is pumped toward the lower surface of the workpiece from the through-holes and the workpiece is pressed onto the nano-imprinting mold from a center of the workpiece toward a periphery of the workpiece while gradually filling the UV-curable resin between the nano-imprinting mold and the workpiece. the UV-curable resin is cured by irradiating the UV-curable resin with UV light in a state where the workpiece is pressed onto the nano-imprinting mold by the pumping pressure of the gas.

US 4954313 A discloses a method for providing void-free low-electrical-resistance conductive cores in vias having an aspect ratio of greater than approximately 6. The method includes the steps of providing a conductive thixotropic paste on the top surface of a substrate having vias provided therein, applying pressure to the paste and concurrently applying pressure to the paste and bottom surface of the substrate to force the thixotropic paste into the vias. Vibratory motion may also be applied to the substrate and paste concurrently with the application of pressure and vacuum. The paste is then dried in a vacuum, and subsequently sintered in a two-step process including a slow ramp up to temperature to allow the paste to outgas followed by a high temperature treatment.

Accordingly, there is a need to provide devices and methods to support and transport a print substrate in a plant for the deposition of print tracks, which eliminate the leakage of the conductive paste in an undesired manner. There is a further need to substantially eliminate the possibility of the printing paste used in a prior step accidentally compromising subsequent printing operations.

There is another need to provide devices and methods that allow limiting to a minimum the downtimes and costs due to replacing the belt, and also the possible printing errors due to an incorrect positioning of the print support on the belt.

There is a further need to reduce waste of the print paste by suitably controlling the level of filling of the holes of the substrate, so that it is possible to adjust the level with metal inside the hole, so that it is either flush or partly protruding.

The Applicant has devised and tested embodiments to overcome the shortcomings of the state of the art and to obtain these and other purposes and advantages.

### SUMMARY OF THE INVENTION

The present invention is set forth and characterized in the independent claims, while the dependent claims describe other characteristics of the invention or variants to the main inventive idea.

In one embodiment, an apparatus is provided for supporting and transporting a substrate for depositing print tracks, comprises: a support plate having a support surface suitable for supporting a substrate positioned on the support surface; a first fluid-dynamic circuit configured to generate a first suction condition in one or more first regions of the support surface of the support plate to maintain the substrate adherent to the support surface; and a second fluid-dynamic circuit configured to generate a second suction condition in one or more second regions of the support surface of the support plate, wherein the one or more second regions are positioned to be in fluid communication with one or more holes in the substrate when the substrate is resting on the support surface.

In a further embodiment, the second suction condition is configured to be controlled for allowing controlled filling of the one or more holes in the substrate with a conductive material. In another embodiment, the support surface further comprises a plurality of first holes and a plurality of second holes, the plurality of first holes is in fluid communication with the first fluid-dynamic circuit, the plurality of second holes is in fluid communication with second fluid-dynamic circuit, and the first and second holes open at least partly toward the support surface. In yet another embodiment, at least some of the second holes are positioned to be aligned with the holes of the substrate when the substrate is resting on the support surface. Moreover, at least some of the second holes can have a flared portion terminating near the support surface. Further, a covering element may be disposed at least partly inside at least one of the plurality of second holes, wherein the covering element is retracted with respect to the support surface so as to at least partly cover the at least one second hole. The covering element may be disposed at least partly inside at least one of the plurality of second holes having a flared portion, wherein the covering element is retracted with respect to the support surface so as to at least partly cover the at least one second hole, wherein the covering element is disposed inside the flared portion of the second hole.

In another embodiment, the apparatus may further comprise a control unit configured to control in the second fluid-dynamic circuit at least a first level of suction pressure and a second level of suction pressure, acting at different moments of time and for determinate intervals of time.

In a further embodiment, the apparatus may comprise a first suction means for generating the first suction condition, and a second suction means for generating the second suction condition. In another embodiment, the apparatus may comprise a first suction unit in fluid communication with the first fluid-dynamic circuit, and a second suction unit, independent from the first, in fluid communication with the second fluid-dynamic circuit.

In yet another embodiment, the first fluid-dynamic circuit may be at least partially independent from the second fluid-dynamic circuit, and further comprise a base element coupled to a first pneumatic connection and a second pneumatic connection, a support platform, disposed above the base element, and a diffusion element, disposed above the support platform, wherein the support plate is disposed above the diffusion element. Moreover, the apparatus may comprise one or more conduits formed between the support platform and the base element, and one or more holes in the support platform in fluid communication with the one or more conduits, and in fluid communication with the first holes in the support surface.

In addition, the apparatus may further comprise a cavity in the base element that is in fluid communication with the second pneumatic connection, a first interstice formed between the support platform and the diffusion element, wherein the first interstice is in fluid communication with the cavity in the base element, and a second interstice formed between the diffusion element and the support plate, wherein the second interstice is configured to be in fluid communication with the first interstice through either or both of a plurality of holes in the diffusion element and a gap between a perimeter edge of the air diffusion element and the support platform, and wherein the second interstice is in fluid communication with the second holes in the support surface of the support plate.

In other embodiments, a method is provided for depositing conductive or non-conductive material on a print substrate, comprising positioning a print substrate such that a first surface of the substrate is disposed on a support surface of a support and transport unit, using a printing head to deposit a conductive or non-conductive material on a second surface of the substrate, wherein the substrate has holes that extend between the first surface and the second surface, using a first fluid-dynamic circuit associated with the support and transport unit to generate a suction pressure on the substrate suitable to adhere the substrate to the support surface, and using a second fluid-dynamic circuit associated with the support and transport unit to generate a second suction pressure able to provide the controlled filling of the holes with the conductive or non-conductive material, wherein the second fluid-dynamic circuit is at least partly distinct and independent from the first.

In further embodiments, using the second fluid-dynamic circuit further comprises applying at least a first level of suction pressure and a second level of suction pressure at different moments in time and for determinate intervals of time. Other embodiments provide for positioning a print substrate further comprises positioning the substrate on the support surface so as to dispose the respective holes in the substrate in fluid communication with holes in the support surface that are in fluid communication with the second fluid-dynamic circuit. Still other embodiments provide that the conductive or non-conductive material is a conductive material chosen from a group comprising an ink, a paste, a dopant gel, and an etching gel. In further embodiments, the conductive material is a metallic based paste, which further contains glass fibers. In additional embodiments, the metallic based paste further contains a resin. In still further embodiments, the metallic based paste may be a silver based paste. In other embodiments, the metallic based paste may be copper based, or molybdenum based, or a mixture of metallic bases. Alternatively or in addition, the conductive or non-conductive material may be a non-conductive material chosen from a group comprising an ink, a paste, a dielectric paste, a dopant gel, and an etching gel.

In other embodiments, a support and transport unit, also known as printing nest, may be used to support and transport a print substrate in cooperation with a plant for depositing print tracks. The plant (which may be a substantially known type) is provided with at least a printing head suitable to deposit, on the print substrate, at least a print track according to a predetermined pattern. The substrate is provided with a first surface which is rested on a support surface of the support and transport unit, a second surface facing toward the printing head on which, during the printing step, the track is made, and with holes which extend between the first surface and the second surface and which, during the printing step, are filled at least partly with conductive and/or non-conductive material, so as to achieve an electric or insulation connection between the first and second surface of the substrate.

According to one embodiment, the support and transport unit comprises a first fluid-dynamic circuit suitable to generate a first suction condition, to keep the substrate adherent to the support surface of the support and transport unit, and a second fluid-dynamic circuit, distinct and at least partly independent of the first fluid-dynamic circuit, suitable to generate a second condition of controlled suction through the holes of the substrate, to allow the holes to be filled by the conductive or non-conductive material.

The first fluid-dynamic circuit may act on the surface of the substrate in proximity to a continuous zone thereof, that is, where there are no holes, whereas the second fluid-dynamic circuit acts mainly in correspondence with or in proximity to the holes of the substrate which are to be filled.

By suitably controlling the first and second suction condition it is therefore possible, with the first fluid-dynamic circuit, to provide that the substrate remains in a fixed position on the surface of the support surface of the support and transport unit both during printing operations and also during the transport operations, such that very precise tracks are obtained; whereas, with the second fluid-dynamic circuit it is possible to control suitably the level of suction of the material through the holes, both to provide that they are correctly filled and hence to achieve a contact between the first and second surface of the substrate, and also to prevent part of the material from coming into contact with the support surface of the printing unit.

The first and second fluid-dynamic circuits can therefore be activated simultaneously, or distinctly from each other in different moments of time according to needs.

In this way, moreover, thanks to the accurate control of the intensity of suction at least of the second fluid-dynamic circuit, it is not necessary to associate with the support and transport unit, that is, the printing nest, a layer of transpirable material that has to be restored with every work cycle of the substrate. It should be noted though, that embodiments of the invention may also make use of suction, low pressure or pressure differentials, which are transmitted through a layer of transpirable material. Therefore, printing nests configured to use transpirable material are not excluded from the scope of the invention. Various printing nest configurations and apparatuses using printing nests are further described in US Patent Application Nos. 12/257,159 (published as US 2009/0314201) and 12/256,707 (published as US 2009/0265926) to Baccini, which are each incorporated by reference in their entirety, as if fully set out herein. It is to be understood that embodiments described in these applications may be used in accordance with the teachings herein. For example, features relating to tranpirable material may be removed or not utilized, if not needed or desired. Alternatively, suction or pressure control may be applied through transpirable material.

According to one embodiment, the support and transport unit comprises a support plate in the thickness of which a plurality of first holes are made, and second holes which are connected fluidically respectively to the first and second fluid-dynamic circuit.

The first and second holes open at least partly toward the support surface on which the substrate is deposited, to define the suction conditions respectively in the substrate, to make it adhere, and in the holes of the substrate to control the filling of the material.

In some embodiments, at least some of the second holes of the second fluid-dynamic circuit open toward the support surface in correspondence with at least some of the holes of the substrate when the substrate is resting on the support surface. That is, the openings of the second holes toward the support surface are made mating with the disposition of the holes made on the support substrate.

In still other embodiments, at least some of the second holes terminate at the upper part with a flared portion having a plane size greater than that of the holes made in the substrate. In this way it is possible to prevent the support surface from being soiled by the conductive material when the conductive material protrudes, even by a little, from the hole into which it is introduced during the printing step.

According to another embodiment, at least a covering element is suitable to be disposed at least partly inside at least one of the second holes, and retracted with respect to the support surface, so as to at least partly close the second hole and prevent the material printed and taken in from introducing itself through the second fluid-dynamic circuit and changing the suction conditions through the holes of the substrate.

According to a variant, if the second holes made in the support plate are provided with a flared portion, the covering element is disposed at least partly inside the flared portion.

In other forms of embodiment, the support and transport unit comprises a control unit provided to determine at least in the second fluid-dynamic circuit at least a first level of suction and a second level of suction (or a pressure differential) acting at different moments of time and for determinate time intervals. This solution allows to control in a desired manner the ways in which the holes are filled with conductive material, preventing problems of damage to the support surface.

In other forms of embodiment, the first fluid-dynamic circuit and the second fluid-dynamic circuit are associated with suction means suitable to generate the first and second suction condition. It is advantageous to provide that the suction means are associated with switching means, valves or other, which allow to determine independently the suction conditions inside the first and second fluid-dynamic circuit.

In other forms of embodiment, the suction means comprise a first suction unit associated with the first fluid-dynamic circuit and a second suction unit, independent from the first, associated with the second fluid-dynamic circuit.

The present invention also concerns the method for depositing conductive material on a print substrate which is deposited on a support and transport unit of the type described above.

### BRIEF DESCRIPTION OF THE DRAWINGS

So that the manner in which the recited features can be understood in detail, a more particular description of various embodiments may be had by reference to the drawings. It is to be noted that the appended drawings illustrate only representative embodiments, and are therefore not drawn to scale and are not limiting of claim scope.
Figure 1 shows schematically a lay-out of a plant for the deposition of print tracks on a print substrate, in which a support and transport unit according to some embodiments is provided.
Figure 2 shows schematically a variant of Figure 1.
Figure 3 is an exploded view of a support and transport unit according to an embodiment.
Figure 4 is a plane view of the support and transport unit in Figure 3, in the assembled condition.
Figure 5 is a section view from V-to-V in Figure 4.
Figure 6 is a section view from VI-to-VI in Figure 4.
Figure 7 is a section view from VII-to-VII in Figure 4.
Figure 8 is a section view from VIII-to-VIII in Figure 4.
Figure 9 is an enlarged detail of Figure 8, according to a first variant.
Figure 10 is an enlarged detail of Figure 8, according to a second variant.
Figure 11 is a variant of Figure 9.

These and other characteristics are exemplified by the following description of preferential embodiments, given as a non-restrictive example with reference to the attached drawings. To facilitate comprehension, the same reference numbers have been used, where possible, to identify common elements in the drawings. It is to be understood that elements and characteristics of one embodiment can conveniently be incorporated into other forms of embodiment without further clarifications. Therefore, elements and features of one embodiment may be beneficially incorporated in other embodiments without further recitation.

### DETAILED DESCRIPTION

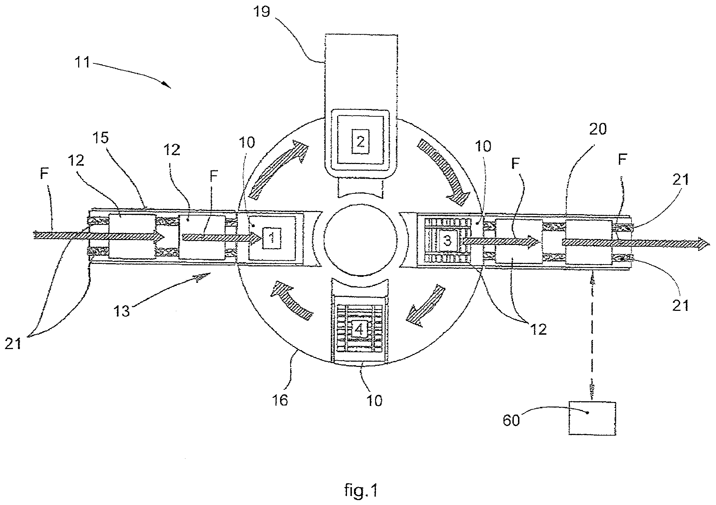

With reference to FIG. 1, a lay-out of a plant 11 is shown, typically used for depositing print tracks on a print support or substrate 12. In the embodiment shown here, the plant 11 comprises a processing unit 13 generally provided with an inlet conveyor 15, a rotary actuator unit 16, a printing head 19, which is also referred to herein as a silkscreen printing head, and an exit conveyor 20. The inlet conveyor 15 and the exit conveyor 20 are suitable to move the substrates 12 respectively toward and out from the rotary actuator unit 16 in a direction of movement indicated by the arrows F.

The rotary actuator unit 16 comprises four printing nests 10, also known as support and transport units, disposed angularly staggered with respect to each other, and each of which is able to be moved between a first position "1" in which it receives a substrate 12 from the inlet conveyor 15, a second position "2" inside the printing head 19 (which may be a silkscreen printing head), a third position "3" to transfer a worked substrate 12 toward the exit conveyor 20, and a fourth position "4" which is an intermediate stage between positions "1" and "3".

The inlet conveyor 15, which is also referred to herein as a feed conveyor, and the exit conveyor 20 comprise a conveyor belt 21 able to move the substrates 12 in the working direction F, or in any case to take them into correspondence with suitable operating positions.

According to a variant, not shown, instead of providing to use the conveyor belt 21, the inlet conveyor 15 and the exit conveyor 20 each comprise a mechanical and/or electromagnetic rail, on which the substrates 12 are able to slide in guided manner, for example supported by the printing nests 10 which will then be moved between the four positions by the rotary actuator unit 16.

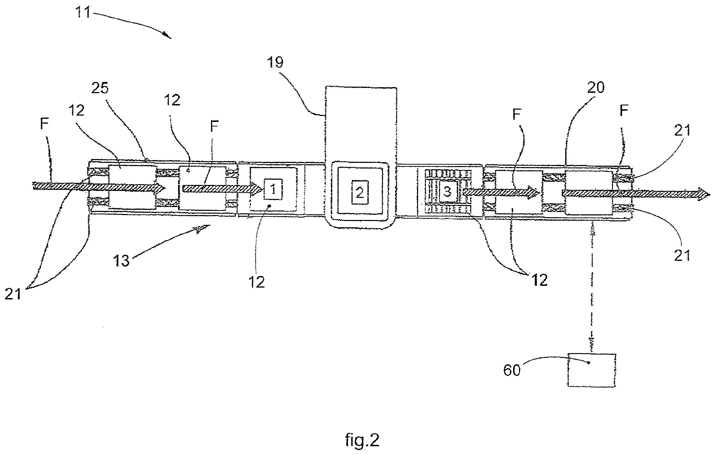

According to the embodiment shown in FIG. 2, a single conveyor 25 is provided, with a conveyor belt 21 that transports the substrates 12 between the position "1", in which a substrate 12 is introduced into the printing head 19, position "2" inside the printing head 19, and the third position "3" in which the worked substrate 12 is discharged from the printing head 19 and conveyed toward other operating stations. In this embodiment the rotary actuator unit 16 is not provided.

According to a variant, not shown, instead of the single conveyor belt 25, a mechanical and/or electromagnet rail is provided, on which the substrates 12 are able to slide in guided manner, for example supported directly by the printing nests 10.

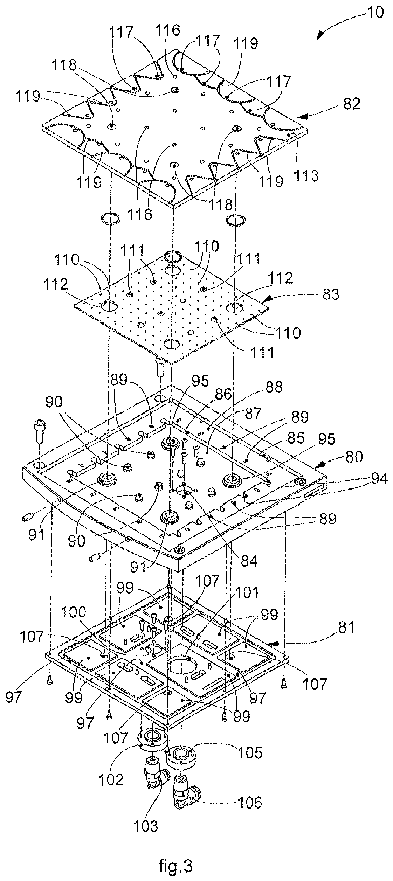

FIG. 3 shows an embodiment in which each printing nest 10 comprises a support platform 80, also known as a panel, with which a base element 81 is associated at the lower part and, on the opposite side, a support plate 82. Between the support plate 82 and the support platform 80 an air diffusion element 83 is interposed, the functions of which will be described hereafter.

The support platform 80 is provided with a first cavity 85 substantially conformed as a frame, and with a second cavity 86, internal with respect to the first cavity 85, substantially square in shape, which in turn defines an inner base surface 87. Between the first cavity 85 and the second cavity 86 an abutment surface 88 is defined, on which, during use, the support plate 82 is disposed adherent. In the first cavity 85, located on the abutment surface 88, a plurality of holes 89 are made, which extend through the entire thickness of the support platform 80. Two of the opposite sides that define the second cavity 86 are provided with a plurality of hollows 94 that define spaces through which suitable instruments are used for access, in order to remove the diffusion element 83 from the support platform 80.

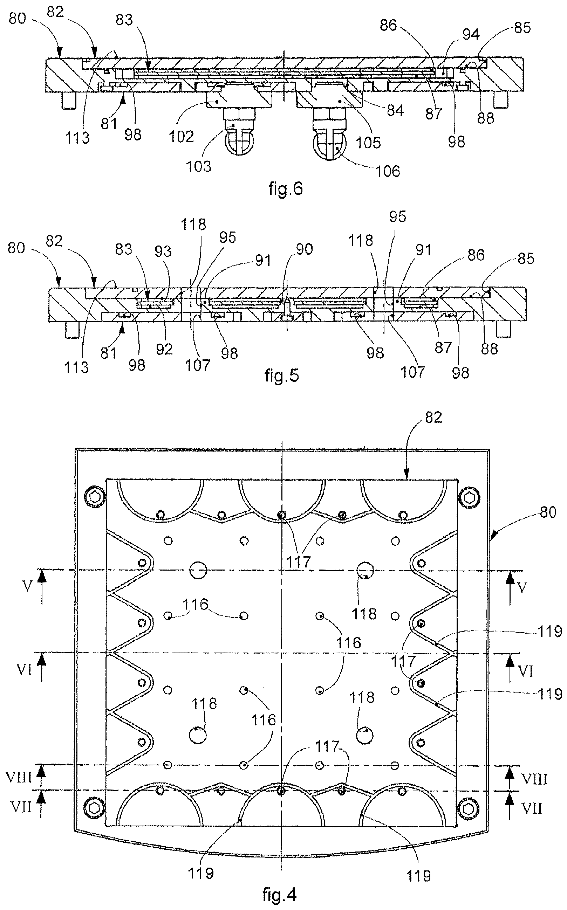

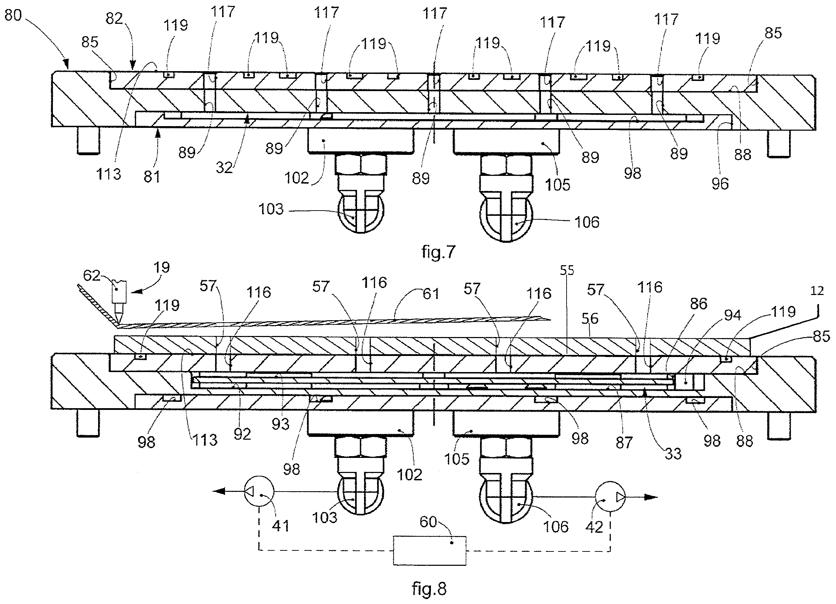

The base surface 87 may be provided with a plurality of first centering pins 90 and second centering pins 91. The second centering pins may be larger in size than the first centering pins 90. In particular, both the first centering pins 90 and the second centering pins 91 are suitable to keep the diffusion element 83 in a determinate position inside the second cavity 86, and distanced from the base surface 87 so as to define with the support platform 80 a first interstice 92 and with the support plate 82 a second interstice 93 (FIGs. 5 and 8). The second centering pins 91 (FIG. 3) are each provided with a hole 95 the function of which will be described hereafter. In the base surface 87, in an inner position thereof, a cavity 84 is also made.

The support platform 80 is also provided with a third cavity 96 (FIG. 7), substantially square, and made on the opposite side from that where the first 85 and the second cavity 86 are made. The third cavity 96 is of a size suitable to accommodate the base element 81.

The base element 81 (see, e.g., FIG. 3) may be conformed substantially as a plate, and a plurality of grooves 97 may be made on the base element 81. At least some of the plurality of grooves 97 may extend peripherally to the edge of the base element 81, so that when the base element 81 is associated with the support platform 80, the holes 89 (of the support platform 80) are directly facing the groove 97.

Other grooves 97 extend toward the inside of the base element 81 to define protruding portions 99 with respect to the bottom surface of the grooves 97. In particular, in proximity to one of the grooves 97 a first hole 100 is made, whereas in proximity to one of the protruding portions 99 a second hole 101 is made. In proximity to the first hole 100 a first pneumatic connection 103 is associated, by means of a first flange 102, and opens toward the grooves 97.

The second hole 101 is associated by means of a second flange 105 to a second pneumatic connection 106 which, when the support platform 80 is associated with the base element 81, opens toward the base surface 87 of the support platform 80.

The protruding portions 99 of the base element 81 are provided with holes 107 which, when the base element 81 is associated with the support platform 80, are substantially aligned with the holes 95 made in the second centering pins 91.

In the assembled condition of the base element 81 with the support platform 80, the protruding portions 99 abut against and adhere with the lower surface of the third cavity 96 of the support platform 80, while the grooves 97 are closed at the upper part so as to define a network of closed conduits 98 (FIGs. 5-8).

As shown in FIG. 3, the diffusion element 83 is substantially flat and square in shape and has plane sizes a little less than that of the second cavity 86. The diffusion element 83 is provided with a plurality of first holes 110 disposed in a matrix configuration and, merely to give an example, having diameter sizes comprised between 0.1 mm and 3 mm. The diffusion element 83 is also provided with second holes 111 and third holes 112 with sizes, and made in determinate positions, suitable to allow them to be positioned inside the first centering pins 90 and respectively the second centering pins 91 of the support platform 80, when the diffusion element 83 is associated with the support platform 80.

The support plate 82 is provided with a support surface 113 on which, during use, the substrate 12 is disposed so that it can be metalized or printed. The support plate 82 is provided with a plurality of first holes 117 and a plurality of second holes 116. The first holes 117 are made on the perimeter of the support plate 82, and in a position such that, when the support plate 82 is associated with the support platform 80, the first holes 117 are substantially coaxial with the holes 89 made in the abutment surface 88. The second holes 116 are disposed according to a predetermined pattern according to the characteristics of the substrate 12, in this case according to a matrix configuration, that is, in the points of intersection between lines and columns, and have a size which, merely to give an example, is comprised between 0.1 mm and 3 mm.

Furthermore, in proximity to the perimeter edge of the support plate 82, a plurality of channels 119 are made, open at the upper part, each of which extends on the support surface 113 so as to surround one of the first holes 117 and to open, in the direction of the thickness, toward the outside in proximity to the perimeter edges of the support plate 82. In particular, the channels 119 extend according to a concave geometry toward the perimeter edge of the support plate 82 and remain confined in a determinate perimeter band of the support surface 113 so that they do not affect the zones where the second holes 116 are made.

The support plate 82 is also provided with third holes 118, in this case four, which when the support plate 82 is associated with the support platform 80, are substantially aligned and coaxial with the holes 95 of the second centering pins 91 and with the holes 107 of the base element 81.

In the assembled condition of the printing nest 10, a distinct first 32 and a second fluid-dynamic circuit 33 are defined, in which it is possible to establish well-defined and different conditions of suction or pressure differential.

In particular, the first fluid-dynamic circuit 32 is defined by the first pneumatic connection 103 which is fluidically connected to the conduits 98 which are fluidically connected to the holes 89 made in the abutment surface 88 of the support platform 80, and which in turn are aligned and coaxial with the first holes 117 of the support plate 82 and open toward its support surface 113.

The second fluid-dynamic circuit 33 is defined by the second pneumatic connection 106 which is fluidically connected directly, through the cavity 84, to the base surface 87 of the support platform 80, and hence to the first interstice 92 defined between the support platform 80 and the diffusion element 83.

The fluidic connection between the first interstice 92 and the second interstice 93 is provided by the first holes 110 and by the gap that is generated between the perimeter edges of the diffusion element 83 and the second cavity 86.

The second interstice 93 is in turn fluidically connected with the second holes 116 which are made in the support plate 82, and which open in turn toward its support surface 113.

In the first 32 and second fluid-dynamic circuit 33, during the printing operations, a first suction condition and a second suction condition are respectively set, which act respectively and distinctly on the first holes 117 and on the second holes 116.

The diffusion element 83 is suitable to distribute equally the second suction condition that is generated in the first interstice 92, in the second interstice 93, so that each of the second holes 116 of the support plate 82 is subjected to the same value of suction or pressure differential.

The first 32 and the second fluid-dynamic circuits 33 also comprise, respectively, a first 41 and a second suction unit 42, which respectively connect to the first pneumatic connection 103, and a second pneumatic connection 106, and determine the action of controlled suction inside the fluid-dynamic circuits 32, 33 independently from each other.

In some preferential forms of embodiment (such as provided in FIG. 8), the second holes 116 of the support plate 82 terminate at the upper part toward the support surface 113 with a flared portion 45 having a larger diameter than that of the corresponding hole.

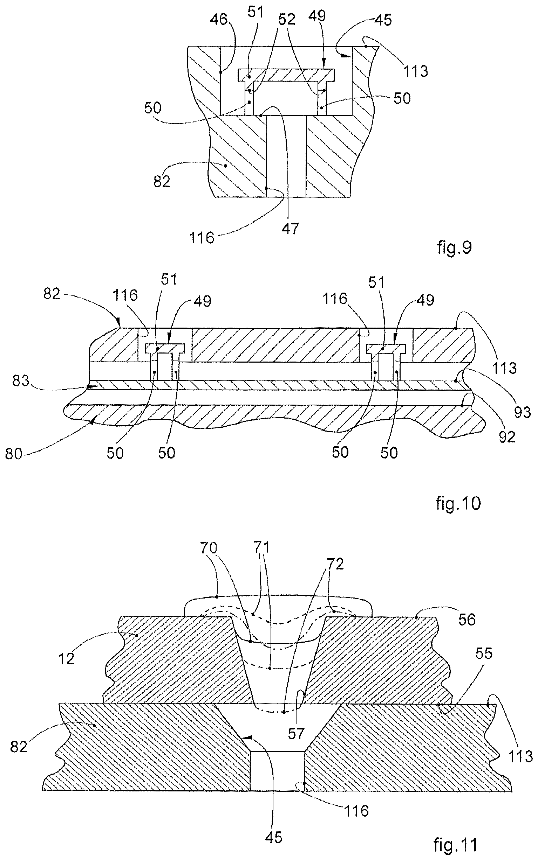

In one such embodiment illustrated by FIG. 9, the flared portion 45 is defined by a lateral surface 46 and by a bottom surface 47. In FIG. 9, the lateral surface 46 is substantially cylindrical and is positioned to be orthogonal to the bottom surface 47.

The terminal end of each second hole 116 is covered at the upper part by a covering element 49 which comprises first segments 50 that extend substantially parallel with respect to the lateral surface 46, and a second segment 51 which is located above the first segments 50 and is substantially parallel to the bottom surface 47. The sizes of the first 50 and the second 51 segments are such that the covering element 49 is retracted inside the flared portion 45, defining an interstice between the support surface 113 and the second segment 51. The first segments 50 are provided with through seatings 52 which allow the fluidic connection between the second holes 116 and the flared portion 45.

In some embodiments, the first segments 50 may comprise a substantially cylindrical body having a larger diameter than a diameter of the second hole 116, and the first segments 50 may be disposed substantially coaxial with the second hole 116.

In further embodiments, the covering element 49 can be a removable type, which may allow it to be replaced, such as may be desired for cleaning or maintenance. In this case, the covering element 49 and the flared portion 45 may be provided with attachment elements which provide for their reciprocal connection, such as threaded connections, same-shape connections, snap-in connections or other mechanical connections. FIG. 9 also illustrates an embodiment in which the flared portion 45 is made in the support plate 82.

FIG. 10 illustrates another embodiment in which the covering elements 49 are associated or made in a single piece with the diffusion element 83. The covering elements 49 are further positioned in coordination with the second holes 116 so that the covering elements 49 are at least partly contained inside the second holes 116.

Another embodiment is illustrated in FIG. 11, in which each of the second holes 116 terminates flared toward the outside. In some further embodiments, an inserted covering element may be excluded. Alternatively, a covering element may be provided.

Turning to FIG. 8, an embodiment for positioning the substrate may be discussed. During the printing operation, the substrate 12 is disposed with a first surface 55 facing and resting on the support surface 113 of the support plate 82. A second surface 56 of the substrate faces toward the printing head 19, and thus the second surface 56 is positioned on an opposite side of the first surface 55 of the substrate. The correct positioning of the substrate 12 on the support plate 82, and its maintenance in position during the printing operations and movements, is provided by the first fluid-dynamic circuit 32. When the first suction unit 41 is activated, a suction (or lower pressure) may be generated inside the first fluid-dynamic circuit 32, which makes the substrate 12 adhere to the support surface 113.

The substrate 12 is provided in a known manner with a plurality of holes 57 which, when filled with conductive material, achieve the electric connection between the second surface 56, on which for example the fingers and busbars are made (not shown) and the first surface 55.

During the printing operations, and before they are started, each hole 57 is disposed in correspondence with the terminal ends of each of the second holes 116 of the support plate 82. In fact, the position in which the second holes 116 are made is defined in relation to the position that the substrate 12 will have to assume when it is disposed on the support plate 82 and the position in which the holes 57 are made in the substrate 12.

During the printing operations, the holes 57 are metalized by being filled with conductive material. The correct filling of the holes 57 is provided by the second fluid-dynamic circuit 33. In fact, when the second suction unit 42 is driven, a suction (or lower pressure than the ambient pressure) is generated which tends to take in, in an adjustable manner and with precision, the filling material that is distributed during the printing step on the surface of the substrate 12.

By suitably controlling the value of the suction pressure of the second suction unit 42, it is possible to provide that the holes 57 are filled uniformly to a desired level, and that the material taken in does not dirty the support surface 113 of the support plate 82. Otherwise, an intervention step would be required for cleaning, or else a layer of transpirable material would be required so as not to dirty the next substrate 12 to be printed. Furthermore, the presence of the covering element 49 can prevent residual material taken in from being introduced into the second interstice 93 and from damaging or changing the suction conditions through the second holes 116.

When the printing nest 10 is assembled, the holes 107 of the base element 81, the holes 95 of the second centering pins 91, and the third holes 118 of the support plate 82, are substantially aligned and coaxial with respect to each other, and through them lifting pins can be introduced (not shown). When the substrate 12 is resting on the support surface 113, the lifting pens can lift it from the support surface 113 so that a suitable removal device can pick up the substrate 12 from the printing nest 10 and send it to subsequent working steps.

The substrates 12 can have a microcrystalline silicon base. In one example, the substrate can be of the type used for creating solar cells. In another example, the type of substrates used for making green-tape ceramic substrates can be provided.

In one embodiment, each printing nest 10 may comprise a lamp, or other similar optical radiation device, to illuminate the substrate 12 positioned thereon so that it can be more easily inspected by an inspection system.

The printing head 19 (illustrated in FIG. 8) used in the plant 11 can be a conventional silkscreen printing head available from Applied Materials Italia S.R.L. In some embodiments, more than one printing head 19 may be used.

The printing head 19 may comprise a plurality of actuators, not shown (for example step motors or servomotors), which may further be in communication with a system controller 60 suitable to adjust a position and/or an angular orientation of a print mask 61, which may be a net (shown schematically in FIG. 8).

The print mask 61 may be a metal foil or sheet with a plurality of holes or fissures or other apertures conformed in the same way as the tracks of the pattern to be obtained on the substrate 12.

A blade 62 associated with the printing head 19 may distribute, in a known manner, a conductive or non-conductive material on the print mask 61, which will in turn define the pattern of the tracks on the substrate 12.

The conductive or non-conductive material can comprise an ink, a paste, a dopant gel, an incision gel, or a masking material. In some embodiments, holes may be filled in with a conductive material, such as a metallic paste. One such conductive paste is a silver (Ag) based paste, which may be selected or utilized so that viscosity and conductivity characteristics allow the holes to be sufficiently filled. The conductive paste may have a viscosity between about 10 and about 1000 Pa·s, depending on the shear rate (i.e., the speed of a test "plate" on which the pasted has been positioned). Silver paste may also have characteristics of low resistivity (few mOhm/square unit area). Other materials can be Cu-AI-Zn-Sn- or Mb-based pastes, or mixtures thereof. Conductive pastes may also contain glass fibers (frits), which allow creating the contact between the cell surface and the paste. Conductive pastes may also (or additionally or alternatively) contain a resin. The resin may help protect the paste from disaggregating after being sintered in a sintering furnace.

The pattern that has to be deposited on the surface of the substrate 12 may be aligned with the substrate automatically, by orienting the print mask 61 according to information received by the controller 60, which processes the information detected by relative TV cameras, for example disposed upstream and downstream of the printing head 19.

It is advantageous to provide that the printing nest 10 (i.e., the support and transport unit) is governed by positioning devices suitable to dispose the substrate 12 on the support surface 113 of the support plate 82, so as to dispose the respective holes 57 in correspondence with the flared portions 45 of the second holes 116, to allow them to be metalized; the terminal portions of the first holes 117 of the support plate 82 instead are disposed in proximity to a substantially continuous surface zone of the substrate 12, that is, such as to allow a more effective action for holding the substrate 12 through suction (or lower pressure than the ambient pressure) on the support surface 113 of the support plate 82.

The presence of the channels 119 on the support surface 113 and of the support plate 82, allows to circumscribe or isolate the low pressure zone exerted by the first fluid-dynamic circuit 32 to only the zone surrounding the first holes 117, preventing the suction from affecting the zones surrounding the second holes 116 too, and hence from altering the suction conditions in the holes 57 of the substrate 12.

In other forms of embodiment, not shown, a drying oven is also associated with the printing head 19, to subject to treatment the material deposited on the substrate 12.

In another embodiment, the plant 11 is an ink jet printing plant and the printing head 19 include ink jet printing components which are configured to deposit a layer of tracks defining the pattern on the substrate 12. In some embodiments, more than one printing head may be used.

The controller 60 facilitates the control and automation of the whole plant 11 and is suitable to control the printing processes, the conveyors, the detectors, the motors, the fluid delivery devices, the suction units and others.

The deposition method may comprise a first step of positioning the substrate 12, fed by the inlet conveyor 15, on the support surface 113 of the printing nest 10.

Then the first suction unit 41 is activated, which acting through the first fluid-dynamic circuit 32 makes the substrate 12 adhere to the support surface 113 and prevents the substrate from accidentally moving.

Merely to give an example, the first suction unit 41 exerts on the substrate 12 an action of suction (or lower pressure) comprised between 1 mbar and 1 bar.

During this step a TV camera located upstream of the printing head 19 provides to detect the position of the substrate 12 in order to control and adjust the correct deposition of the conductive material, by means of the positioning devices.

The substrate 12 is disposed with a first surface 55 resting on the support surface 113 of the support plate 82 and with the respective holes 57 substantially aligned and coaxial with the second holes 116 of the second fluid-dynamic circuit 33. The first holes 117 of the first fluid-dynamic circuit 32 are directly facing the first surface 55 of the substrate 12 and in a position not facing that of the holes 57.

A second step provides to deposit the conductive material on the second surface 56 of the substrate 12. In particular, the blade 62 provides to distribute uniformly on the print mask 61 a uniform layer of conductive material, which fills the seatings and fissures of the print mask 61 to define the desired pattern on the second surface 56.

The second suction unit 42 is then activated which generates suction through the second holes 116. This suction condition allows the conductive material previously deposited to fill the hole 57 uniformly, and hence to define a condition of electric contact between the first 55 and second surface 56. By properly controlling the suction pressure value it is possible to prevent the conductive material from polluting the support surface 113 or the second segment 51 of the covering element 49.

It is advantageous to provide the controlled application in the second fluid-dynamic circuit 33 of two levels of pressure which act at different moments in time. This application step of the two levels of pressure is suitably controlled by the controller 60.

In particular, it is provided that during the deposition of the conductive material the second fluid-dynamic circuit 33 is subjected to at least a first pressure value that provides that the conductive material partly fills the hole 57, for example to about half of its volume, and as soon as this deposition operation is terminated, at least a second pressure value is applied, which provides that the material reaches the first surface 55 of the substrate 12, or at least that it reaches only a determinate level of filling the hole 57.

In other forms of embodiment, it is also possible to suitably control the second pressure value so as to allow, for example, only the surface filling of the hole 57, that is, only of its perimeter walls, so as to leave a gap in the hole. For example, the gap may pass all the way through the hole, such as to leave the center of the hole still open.

The at least first and the at least second pressure value set during the process are a function of the density/consistency, viscosity, surface tension of the conductive material used. Simply to give an example, FIG. 11 shows schematically the level of conductive material at different moments in time, and in particular a first level 70 corresponding to the material just deposited through the print mask 61, a second level 71 consequent to the action of suction given by the first pressure value, and a third level 72 consequent to the action of suction due to the second pressure value.

These suction (or lower pressure) values are applied for determinate periods of time, for example for a period comprised between 0.1 sec and 2 sec.

As soon as this step is terminated, the substrate 12 is taken to a discharge condition (corresponding to the third position "3") for subsequent operations.

It is clear that modifications and/or additions of parts and/or steps may be made to the printing nest 10 (i.e., the support and transport unit) for a substrate 12 and the relative deposition method as described heretofore, without departing from the field and scope of the present invention.

While the foregoing is directed to embodiments of the present invention, other and further embodiments of the invention may be devised without departing from the basic scope thereof, and the scope thereof is determined by the claims that follow.

## Claims

1. An apparatus configured for supporting and transporting a substrate for depositing print tracks, comprising:
a substrate (12) to be supported and transported;
a support plate (82) having a support surface (113) suitable for supporting a substrate (12) positioned on the support surface (113);
a first fluid-dynamic circuit (32) configured to generate a first suction condition in one or more first regions of the support surface (113) of the support plate (82) to maintain the substrate (12) adherent to the support surface (113); and
a second fluid-dynamic circuit (33) configured to generate a second suction condition in one or more second regions of the support surface (113) of the support plate (82), wherein the apparatus is **characterized in that**:
the substrate (12) has one or more holes (57);
the one or more second regions are positioned to be in fluid communication with the one or more holes (57) in the substrate (12) when the substrate (12) is resting on the support surface (113), and the second suction condition is controllable for allowing controlled filling of the one or more holes (57) in the substrate (12) with a conductive material.

2. The apparatus of claim 1, wherein the support surface (113) further has a plurality of first holes (117) and a plurality of second holes (116), the plurality of first holes (117) is in fluid communication with the first fluid-dynamic circuit (32), the plurality of second holes (116) is in fluid communication with the second fluid-dynamic circuit (33), and the first (117) and second holes (116) open at least partly toward the support surface (113).

3. The apparatus of claim 2, wherein at least some of the second holes (116) are positioned to be alignable with the holes (57) of the substrate (12) when the substrate (12) is resting on the support surface (113).

4. The apparatus of claim 3, wherein at least some of the second holes (116) have a flared portion (45) terminating near the support surface (113).

5. The apparatus of claim 3, further comprising a covering element (49) disposed at least partly inside at least one of the plurality of second holes (116), wherein the covering element (49) is retracted with respect to the support surface (113) so as to at least partly cover the at least one second hole (116).

6. The apparatus of claim 4, further comprising a covering element (49) disposed at least partly inside at least one of the plurality of second holes (116) having a flared portion (45), wherein the covering element (49) is retracted with respect to the support surface (113) so as to at least partly cover the at least one second hole (116), wherein the covering element (49) is disposed inside the flared portion (45) of the second hole.

7. The apparatus of claim 1, further comprising a control unit configured to control in the second fluid-dynamic circuit (33) at least a first level of suction pressure and a second level of suction pressure, acting at different moments of time and for determinate intervals of time.

8. The apparatus of claim 1, further comprising:
a first suction unit (41) for generating the first suction condition; and
a second suction unit (42) for generating the second suction condition.

9. The apparatus of claim 1, further comprising:
a first suction unit (41) in fluid communication with the first fluid-dynamic circuit (32); and
a second suction unit (42), independent from the first, in fluid communication with the second fluid-dynamic circuit (33).

10. The apparatus of claim 2, wherein the first fluid-dynamic circuit (32) is at least partially independent from the second fluid-dynamic circuit (33), and further comprising:
a base element (81) coupled to a first pneumatic connection (103) and a second pneumatic connection (106);
a support platform (80), disposed above the base element (81); and
a diffusion element (83), disposed above the support platform (80), wherein the support plate (82) is disposed above the diffusion element (83).

11. The apparatus of claim 10, further comprising:
one or more conduits (98) formed between the support platform and the base element; and
one or more holes in the support platform (80) in fluid communication with the one or more conduits (98), and in fluid communication with the first holes in the support surface (113).

12. The apparatus of claim 11, further comprising:
a cavity (84) in the base element (81) that is in fluid communication with the second pneumatic connection (106);
a first interstice (92) formed between the support platform (80) and the diffusion element (83),
wherein the first interstice (92) is in fluid communication with the cavity (84) in the base element (81); and
a second interstice (93) formed between the diffusion element (83) and the support plate (113), wherein the second interstice (93) is configured to be in fluid communication with the first interstice (92) through either or both of a plurality of holes (110) in the diffusion element (83) and a gap between a perimeter edge of the air diffusion element (83) and the support platform, and wherein the second interstice (93) is in fluid communication with the second holes in the support surface (113) of the support plate (82).

13. A method for depositing conductive or non-conductive material on a print substrate (12), comprising:
positioning a print substrate (12) such that a first surface (55) of the substrate (12) is disposed on a support surface (113) of a support and transport unit (10);
using a printing head (19) to deposit a conductive or non-conductive material on a second surface (56) of the substrate (12), wherein the substrate (12) has holes (57) that extend between the first surface (55) and the second surface (56);
using a first fluid-dynamic circuit (32) associated with the support and transport unit (10) to generate a suction pressure on the substrate (12) suitable to adhere the substrate (12) to the support surface (113); and
using a second fluid-dynamic circuit (33) associated with the support and transport unit (10) to generate a second suction pressure able to provide the controlled filling of the holes (57) with the conductive or non-conductive material, wherein the second fluid-dynamic circuit (33) is at least partly distinct and independent from the first (32).

14. The method of claim 13, wherein using the second fluid-dynamic circuit (33) further comprises applying at least a first level of suction pressure and a second level of suction pressure at different moments in time and for determinate intervals of time.

## Patentansprüche

1. Vorrichtung, dafür konfiguriert, ein Substrat zum Ablagern von Druckspuren zu tragen und zu transportieren, Folgendes umfassend:
ein Substrat (12), das zu tragen und zu transportieren ist,
eine Trageplatte (82) mit einer Tragefläche (113), die zum Tragen eines Substrats (12) geeignet ist, das auf der Tragefläche (113) positioniert ist,
einen ersten fluid-dynamischen Kreislauf (32), der dafür konfiguriert ist, einen ersten Saugzustand in einem oder mehreren ersten Bereichen der Tragefläche (113) der Trageplatte (82) zu erzeugen, um das Substrat (12) an der Tragefläche (113) haftend zu halten, und
einen zweiten fluid-dynamischen Kreislauf (33), der dafür konfiguriert ist, einen zweiten Saugzustand in einem oder mehreren zweiten Bereichen der Tragefläche (113) der Trageplatte (82) zu erzeugen, wobei die Vorrichtung **dadurch gekennzeichnet ist, dass**:
das Substrat (12) eine oder mehrere Öffnungen (57) aufweist,
der eine oder die mehreren zweiten Bereiche dafür positioniert sind, in Fluidverbindung mit der einen oder den mehreren Öffnungen (57) in dem Substrat (12) zu stehen, wenn das Substrat (12) auf der Tragefläche (113) liegt, und
der zweite Saugzustand steuerbar ist, um ein gesteuertes Füllen der einen oder der mehreren Öffnungen (57) in dem Substrat (12) mit einem leitenden Material zu ermöglichen.

2. Vorrichtung nach Anspruch 1, wobei die Tragefläche (113) ferner mehrere erste Öffnungen (117) und mehrere zweite Öffnungen (116) aufweist, wobei die mehreren ersten Öffnungen (117) in Fluidverbindung mit dem ersten fluid-dynamischen Kreislauf (32) stehen, die mehreren zweiten Öffnungen (116) in Fluidverbindung mit dem zweiten fluid-dynamischen Kreislauf (33) stehen und sich die ersten (117) und die zweiten Öffnungen (116) zumindest teilweise zur Tragefläche (113) hin öffnen.

3. Vorrichtung nach Anspruch 2, wobei zumindest einige der zweiten Öffnungen (116) dafür positioniert sind, an den Öffnungen (57) des Substrats (12) ausrichtbar zu sein, wenn das Substrat (12) auf der Tragefläche (113) liegt.

4. Vorrichtung nach Anspruch 3, wobei zumindest einige der zweiten Öffnungen (116) einen aufgeweiteten Abschnitt (45) aufweisen, der nahe der Tragefläche (113) endet.

5. Vorrichtung nach Anspruch 3, ferner ein Abdeckelement (49) umfassend, das zumindest teilweise im Inneren von mindestens einer der mehreren zweiten Öffnungen (116) angeordnet ist, wobei das Abdeckelement (49) in Bezug aus die Tragefläche (113) derart zurückgezogen ist, dass es die mindestens eine zweite Öffnung (116) zumindest teilweise abdeckt.

6. Vorrichtung nach Anspruch 4, ferner ein Abdeckelement (49) umfassend, das zumindest teilweise im Inneren von mindestens einer der mehreren zweiten Öffnungen (116) mit einem aufgeweiteten Abschnitt (45) angeordnet ist, wobei das Abdeckelement (49) in Bezug auf die Tragefläche (113) derart zurückgezogen ist, dass es die mindestens eine zweite Öffnung (116) zumindest teilweise abdeckt, wobei das Abdeckelement (49) im Inneren des aufgeweiteten Abschnitts (45) der zweiten Öffnung angeordnet ist.

7. Vorrichtung nach Anspruch 1, ferner eine Steuereinheit umfassend, die dafür konfiguriert ist, mindestens eine erste Höhe des Saugdrucks und eine zweite Höhe des Saugdrucks in dem zweiten fluid-dynamischen Kreislauf (33) zu steuern, die zu verschiedenen Zeitpunkten und über bestimmte Zeitintervalle wirken.

8. Vorrichtung nach Anspruch 1, ferner Folgendes umfassend:
eine erste Saugeinheit (41) zum Erzeugen des ersten Saugzustands und
eine zweite Saugeinheit (42) zum Erzeugen des zweiten Saugzustands.

9. Vorrichtung nach Anspruch 1, ferner Folgendes umfassend:
eine erste Saugeinheit (41) in Fluidverbindung mit dem ersten fluid-dynamischen Kreislauf (32) und
eine zweite Saugeinheit (42), unabhängig von der ersten, in Fluidverbindung mit dem zweiten fluid-dynamischen Kreislauf (33).

10. Vorrichtung nach Anspruch 2, wobei der erste fluid-dynamische Kreislauf (32) zumindest teilweise von dem zweiten fluid-dynamischen Kreislauf (33) unabhängig ist und ferner Folgendes umfasst:
ein Basiselement (81), das mit einer ersten Pneumatikverbindung (103) und einer zweiten Pneumatikverbindung (106) gekoppelt ist,
eine Trageplattform (80), die über dem Basiselement (81) angeordnet ist, und
ein Diffusionselement (83), das über der Trageplattform (80) angeordnet ist, wobei die Tragplatte (82) über dem Diffusionselement (83) angeordnet ist.

11. Vorrichtung nach Anspruch 10, ferner Folgendes umfassend:
eine oder mehrere Leitungen (98), die zwischen der Tragplattform und dem Basiselement gebildet sind, und
eine oder mehrere Öffnungen in der Trageplattform (80) in Fluidverbindung mit der einen oder den mehreren Leitungen (98) und in Fluidverbindung mit den ersten Öffnungen in der Tragefläche (113).

12. Vorrichtung nach Anspruch 11, ferner Folgendes umfassend:
einen Hohlraum (84) in dem Basiselement (81), der in Fluidverbindung mit der zweiten Pneumatikverbindung (106) steht,
einen ersten Zwischenraum (92), der zwischen der Trageplattform (80) und dem Diffusionselement (83) gebildet ist, wobei der erste Zwischenraum (92) in Fluidverbindung mit dem Hohlraum (84) in dem Basiselement (81) steht, und
einen zweiten Zwischenraum, der zwischen dem Diffusionselement (83) und der Trageplatte (113) gebildet ist, wobei der zweite Zwischenraum (93) dafür konfiguriert ist, durch mehrere Öffnungen (110) in dem Diffusionselement und/oder einen Spalt zwischen einem Umfangsrand des Luftdiffusionselements (83) und der Trageplattform in Fluidverbindung mit dem ersten Zwischenraum (92) zu stehen, und wobei der zweite Zwischenraum (93) in Fluidverbindung mit den zweiten Öffnungen in der Tragefläche (113) der Trageplatte (82) steht.

13. Verfahren zum Ablagern von leitendem oder nicht leitendem Material auf einem Drucksubstrat (12), Folgendes umfassend:
Positionieren eines Drucksubstrats (12) derart, dass eine erste Oberfläche (55) des Substrats (12) auf einer Tragefläche (113) einer Trage- und Transporteinheit (10) angeordnet ist,
Verwenden eines Druckkopfes (19), um ein leitendes oder ein nicht-leitendes Material auf einer zweiten Oberfläche (56) des Substrats (12) abzuscheiden, wobei das Substrat (12) Öffnungen (57) aufweist, die sich zwischen der ersten Oberfläche (55) und der zweiten Oberfläche (56) erstrecken,
Verwenden eines ersten fluid-dynamischen Kreislaufs (32), welcher der Trage- und Transporteinheit (10) zugeordnet ist, um auf dem Substrat (12) einen Saugdruck zu erzeugen, der geeignet ist, das Substrat (12) an die Tragefläche (113) anzuheften, und
Verwenden eines zweiten fluid-dynamischen Kreislaufs (33), welcher der Trage- und Transporteinheit (10) zugeordnet ist, um einen zweiten Saugdruck zu erzeugen, der in der Lage ist, das gesteuerte Füllen der Öffnungen (57) mit dem leitenden oder dem nicht-leitenden Material bereitzustellen, wobei der zweite fluid-dynamische Kreislauf (33) zumindest teilweise von dem ersten (32) getrennt und unabhängig ist.

14. Verfahren nach Anspruch 13, wobei das Verwenden des zweiten fluid-dynamischen Kreislaufs (33) ferner das Anlegen von mindestens einer ersten Höhe des Saugdrucks und einer zweiten Höhe des Saugdrucks zu verschiedenen Zeitpunkten und über bestimmte Zeitintervalle umfasst.

## Revendications

1. Appareil configuré pour supporter et transporter un substrat pour déposer des pistes d'impression, comprenant :
un substrat (12) destiné à être supporté et transporté ;
une plaque de support (82) ayant une surface de support (113) adaptée pour supporter un substrat (12) positionné sur la surface de support (113) ;
un premier circuit fluido-dynamique (32) configuré pour générer un premier état d'aspiration dans une ou plusieurs premières zones de la surface de support (113) de la plaque de support (82) pour maintenir le substrat (12) adhérant à la surface de support (113) ; et
un second circuit fluido-dynamique (33) configuré pour générer un second état d'aspiration dans une ou plusieurs secondes zones de la surface de support (113) de la plaque de support (82), dans lequel l'appareil est **caractérisé en ce que** :
le substrat (12) a un ou plusieurs trous (57) ;
la ou les secondes zones sont positionnées pour être en communication fluidique avec le ou les trous (57) dans le substrat (12) lorsque le substrat (12) est en appui sur la surface de support (113), et le second état d'aspiration est commandable pour permettre un remplissage commandé du ou des trous (57) dans le substrat (12) avec un matériau conducteur.

2. Appareil selon la revendication 1, dans lequel la surface de support (113) a en outre une pluralité de premiers trous (117) et une pluralité de seconds trous (116), la pluralité de premiers trous (117) est en communication fluidique avec le premier circuit fluido-dynamique (32), la pluralité de seconds trous (116) est en communication fluidique avec le second circuit fluido-dynamique (33), et les premiers (117) et seconds trous (116) débouchent au moins partiellement vers la surface de support (113).

3. Appareil selon la revendication 2, dans lequel au moins certains des seconds trous (116) sont positionnés pour pouvoir être alignés avec les trous (57) du substrat (12) lorsque le substrat (12) est en appui sur la surface de support (113).

4. Appareil selon la revendication 3, dans lequel au moins certains des seconds trous (116) ont une partie évasée (45) se terminant près de la surface de support (113).

5. Appareil selon la revendication 3, comprenant en outre un élément de recouvrement (49) disposé au moins en partie à l'intérieur d'au moins un de la pluralité de seconds trous (116), dans lequel l'élément de recouvrement (49) est rétracté par rapport à la surface de support (113) de manière à recouvrir au moins en partie le au moins un second trou (116).

6. Appareil selon la revendication 4, comprenant en outre un élément de recouvrement (49) disposé au moins en partie à l'intérieur d'au moins un parmi la pluralité de seconds trous (116) ayant une partie évasée (45), dans lequel l'élément de recouvrement (49) est rétracté par rapport à la surface de support (113) de manière à recouvrir au moins partiellement le au moins un second trou (116), dans lequel l'élément de recouvrement (49) est disposé à l'intérieur de la partie évasée (45) du second trou.

7. Appareil selon la revendication 1, comprenant en outre une unité de commande configurée pour commander dans le second circuit fluido-dynamique (33) au moins un premier niveau de pression d'aspiration et un second niveau de pression d'aspiration, agissant à différents moments dans le temps et pour des intervalles de temps déterminés.

8. Appareil selon la revendication 1, comprenant en outre :
une première unité d'aspiration (41) pour générer le premier état d'aspiration ; et
une seconde unité d'aspiration (42) pour générer le second état d'aspiration.

9. Appareil selon la revendication 1, comprenant en outre :
une première unité d'aspiration (41) en communication fluidique avec le premier circuit fluido-dynamique (32) ; et
une seconde unité d'aspiration (42), indépendante de la première, en communication fluidique avec le second circuit fluido-dynamique (33).

10. Appareil selon la revendication 2, dans lequel le premier circuit fluido-dynamique (32) est au moins partiellement indépendant du second circuit fluido-dynamique (33), et comprenant en outre :
un élément de base (81) couplé à un premier raccord pneumatique (103) et à un second raccord pneumatique (106) ;
une plate-forme de support (80), disposée au-dessus de l'élément de base (81) ; et
un élément de diffusion (83), disposé au-dessus de la plate-forme de support (80), dans lequel la plaque de support (82) est disposée au-dessus de l'élément de diffusion (83).

11. Appareil selon la revendication 10, comprenant en outre :
une ou plusieurs conduites (98) formées entre la plate-forme de support et l'élément de base ; et
un ou plusieurs trous dans la plate-forme de support (80) en communication fluidique avec la ou les conduites (98), et en communication fluidique avec les premiers trous dans la surface de support (113).

12. Appareil selon la revendication 11, comprenant en outre :
une cavité (84) dans l'élément de base (81) qui est en communication fluidique avec le second raccord pneumatique (106) ;
un premier interstice (92) formé entre la plate-forme de support (80) et l'élément de diffusion (83), dans lequel le premier interstice (92) est en communication fluidique avec la cavité (84) dans l'élément de base (81) ; et
un second interstice (93) formé entre l'élément de diffusion (83) et la plaque de support (113), dans lequel le second interstice (93) est configuré pour être en communication fluidique avec le premier interstice (92) par soit l'un ou l'autre parmi une pluralité de trous (110) dans l'élément de diffusion (83) et un écart entre un bord de périmètre de l'élément de diffusion d'air (83) et la plate-forme de support, soit les deux, et dans lequel le second interstice (93) est en communication fluidique avec les seconds trous dans la surface de support (113) de la plaque de support (82).

13. Procédé pour déposer un matériau conducteur ou non conducteur dans un substrat d'impression (12), comprenant :
positionner un substrat d'impression (12) de telle sorte qu'une première surface (55) du substrat (12) soit disposée sur une surface de support (113) d'une unité de support et de transport (10) ;
utiliser une tête d'impression (19) pour déposer un matériau conducteur ou non conducteur sur une seconde surface (56) du substrat (12), dans lequel le substrat (12) a des trous (57) qui s'étendent entre la première surface (55) et la seconde surface (56) ;
utiliser un premier circuit fluido-dynamique (32) associé à l'unité de support et de transport (10) pour générer une pression d'aspiration sur le substrat (12) adaptée pour faire adhérer le substrat (12) à la surface de support (113) ; et
utiliser un second circuit fluido-dynamique (33) associé à l'unité de support et de transport (10) pour générer une seconde pression d'aspiration pouvant assurer le remplissage commandé des trous (57) avec le matériau conducteur ou non conducteur, dans lequel le second circuit fluido-dynamique (33) est au moins partiellement distinct et indépendant du premier (32).

14. Procédé selon la revendication 13, dans lequel l'utilisation du second circuit fluido-dynamique (33) comprend en outre l'application d'au moins un premier niveau de pression d'aspiration et d'un second niveau de pression d'aspiration à différents moments dans le temps et pour des intervalles de temps déterminés.
